Europäisches Patentamt

**European Patent Office**

Office européen des brevets

(11) Publication number: **0 319 912**
**A2**

# (12) EUROPEAN PATENT APPLICATION

(21) Application number: **88120356.6**

(22) Date of filing: **06.12.88**

(51) Int. Cl.⁴: **G01N 23/223 , H01J 35/08 , H01J 35/14**

(30) Priority: **07.12.87 US 129476**

(43) Date of publication of application:
**14.06.89 Bulletin 89/24**

(84) Designated Contracting States:
**AT BE CH DE ES FR GB GR IT LI LU NL SE**

(71) Applicant: **Wang, Chia-Gee, Dr.**
**44, Glenwood Road**
**Millwood New York 10546(US)**

(72) Inventor: **Wang, Chia-Gee, Dr.**
**44, Glenwood Road**
**Millwood New York 10546(US)**

(74) Representative: **Baillie, Iain Cameron et al**
**c/o Ladas & Parry Isartorplatz 5**
**D-8000 München 2(DE)**

(54) **Method and apparatus for investigating materials with X-rays.**

(57) A method of investigating materials by the use of x-rays comprises focusing an accelerated beam of electrons (9) in an evacuated space on a metal foil (12) facing said evacuated space, said metal foil (12) being supported on a first surface 13 a of a support substrate (13) which is substantially transparent to x-rays and has a second surface 13 b outside said evacuated space, thereby generating x-rays in said metal foil (12), placing a specimen (14) of a material to be investigated adjacent to said second surface 13 b of said substrate 13 in a position exposed to the x-rays generated in said metal foil (12), and selectively detecting x-rays from said specimen (14) which are characterisitc of properties of a region of said specimen (14). The invention particularly relates to investigating biological specimens under ambient conditions of the environment. An apparatus includes an x-ray microscope embodiment.

FIG. I

# METHOD AND APPARATUS FOR INVESTIGATING MATERIALS WITH X-RAYS

## 1. Field of the Invention

This invention relates to a method of investigating materials using x-rays and to apparatus therefor. More particularly, the invention relates to investigating biological specimens under ambient conditions of the environment by means of an x-ray microscope (XM). In a preferred embodiment, a novel scanning x-ray microscope (SXM) is provided and utilized in the method of the invention.

From the time of the discovery of x-ray radiation, x-rays have been utilized in many different ways for the investigation of materials including biological materials. Microscopes have been of great importance in the investigation of both biological and other materials. Optical microscopes are limited in resolution by the wavelength of the photons in a beam of visible light. The electron microscope (EM) was developed using the discovery of the wave property of electrons. Electrons can have extremely short wavelengths which enables the EM to have very high magnification and greatly improved resolution compared with optical microscopes. Electrons are also employed in a scanning electron microscope (SEM), which operates in a different way from the EM. An SEM employs a beam of electrons focused to a spot having a diameter of several nm which is scanned over the surface of a sample in a pattern generating secondary electrons which are detected and amplified for each pixel to collectively compose a picture of the surface of the sample. Compared with an optical microscope, a far better resolution and depth of field is obtained.

However, investigation of materials with an EM or SEM requires examining the specimens in an evacuated environment for the passage of electrons, as well as treatment of the specimens. For investigation with an EM, a very thin specimen must be prepared and stained with heavy metals. The sample for a SEM requires coating with heavy metals.

## 2. Description of Related Art

A scanning x-ray microscope (SEM) is disclosed in United States Patent No. 4, 317. 036 granted on February 23, 1982 to Chia-Gee Wang. This patent discloses that prior attempts to construct x-ray microscopes were based on equipping electron microscopes with x-ray detectors and that such a system can function as an x-ray microscope with scanning electron detection. Among the factors stated to cause the prior XM to become complex and expensive was the need for a vacuum housing for the electron beam and the specimen. The invention of this patent was directed towards a more simple system in which a beam of x-rays was attempted to be focused onto a small spot for scanning the beam over a specimen, without the use of vacuum. However, it has been found that the necessary precise focusing of the x-ray beam is complex and difficult in many cases. Accordingly, there is a need in the art for a system which avoids the difficulty of focusing an x-ray beam, while providing a means of analyzing materials or specimens under normal conditions not involving the application of a vacuum to the specimens.

Many types of equipment have been developed to utilize x-rays for investigation or analysis of materials. One such type is an x-ray analyzer, electron-micro probe, generally described in "Van Nostrand's Scientific Encyclopedia", Sixth Edition, pages 3041-3044, the disclosure of which is incorporated herein by reference. This instrument is mainly used for metallurgical studies but properly prepared biological specimens may also be analyzed. An optical microscope is used to identify a point of interest on the specimen to be analyzed. An electron beam is focused on such point on the specimen and resulting x-rays are detected and processed to provide quantitative data. In the instrument of this reference, the electron beam is focused directly onto the specimen, both the beam and the specimen being under vacuum. The reference further discloses the production of electron beams and detectors for detection of x-rays.

The field is generally reviewed in "X-ray Microscopy", Proceedings of the International Symposium, Gottingen, Fed. Rep. of Germany, September, 14-16, 1983, edited by G. Schmahl and D. Rudolph, Springer-Verlag, 1984, the contents being given on pages vii-ix.

X-rays have also been used for the detection of atoms in biological specimens using monochromatic x-rays, as disclosed in United States Patent No. 4,239,966 issued on December 16, 1980 and United States Patent No. 4,382,181 issued on May 3, 1983, both issued to Chia-Gee Wang.

An article in SCIENCE, vol. 237, 14 August, 1987, pages 733-724 discusses current research in scanning x-ray microscopy. The article states that biological material in an aqueous environment has been imaged by scanning x-ray microscopy employing a synchrotron light source. X-rays from the light source are focused with use of a Fresnel zone plate. The system is described as not being perfected in view of lengthy time to record images so that dynamic processes cannot be studied and because of noise in the images. Future attempts are to involve brighter soft (long wavelength) x-ray sources, but the article states that it is yet to be demonstrated that cell structures will always survive this soft and intense x-ray dose. Also disclosed in the article are other prior techniques such as contact x-ray micrography in which shadowgraphs of samples illuminated by an x-ray beam are recorded by lithographic means and a transmission electron microscope is used to magnify the image. Prior work has also involved the x-ray analog of an optical microscope. Both the contact method and the optical analog method utilize an intense beam of soft x-rays from a synchrotron light source. The use of a scanning instrument is suggested because of the potential to employ a lower radiation dose and to follow changes within living cells, but the disadvantage of scanning is explained as involving the need to use a very bright x-ray source.

In accordance with the present invention there is provided a method of investigating materials by the use of x-rays, which comprises focusing an accelerated beam of electrons in an evacuated space on a metal foil facing said evacuated space, said metal foil being supported on a first surface of a support substrate which is substantially transparent to x-rays and has a second surface outside evacuated space, thereby generating x-rays in said metal foil, placing a specimen of a material to be investigated adjacent to said second surface of said substrate in a position exposed to the x-rays generated in said metal foil, and selectively detecting x-rays from said specimen which are characteristic of properties of a region of said specimen.

Also provided according to the invention is an apparatus for investigating materials by the use of x- rays, which comprises a chamber adapted to be maintained under vacuum, said chamber having a wall which has an aperture in which is mounted a support substrate composed of a material substantially transparent to x-rays, said support substrate having a first surface facing the interior of said chamber and a second surface facing outside said chamber, said first surface of the support substrate having thereon a metal foil exposed to the interior of the chamber, means for focusing a beam of electrons within said chamber on said metal foil, means for positioning a specimen outside said chamber adjacent to said second surface of the support substrate, and at least one x-ray detector positioned to detect x-rays leaving said specimen.

BRIEF DESCRIPTION OF THE DRAWINGS

Fig. 1 is a schematic elevational view partly in cross-section of an x-ray microscope of the present invention.

Fig. 2 is a schematic elevational view partly in cross-section of a scanning x-ray microscope of the present invention.

Fig. 3 is a schematic representation of the production of images in accordance with the present invention.

Fig. 4 is a monte carlo computer simulation of the electron trajectories in an aluminum layer.

Fig. 5 is a computer simulation of x-ray productions resulting from the electron trajectories depicted in Fig. 4.

Fig. 6 is a diagrammatic illustration of the relation between specimen and detector.

Fig. 7 is a diagrammatic illustration partly in cross-section of the use of a charge-coupled-device detector.

The invention of the EM in 1932 provided biomedical scientists with a very important instrument for studying cells in fine detail. The resulting great progress in cell biology set the stage for the most important discoveries of modern science, namely, the identification of DNA as the carrier of genetic information by Avery and associates in 1944, and the discovery of the structure of DNA and the basis of the genetic code by Watson and Crick in 1953. Molecular biology emerged to become a powerful new discipline, and particularly with the introduction of recombinant DNA techniques in recent years, has undergone an explosive growth.

However, important biological and biochemical information, such as details of cellular dynamic processes cannot be obtained from EM images which are of a treated specimen at a fixed point in time.

A biologically viable peptide or protein, for example, often cannot readily be created by simply synthesizing it from its corresponding DNA sequence. Much information regarding cellular controls is unknown, and fine details of cellular processes, particularly of biochemical transport, can only be studied by indirect means. A convenient instrument for directly viewing cellular dynamic processes under physiological conditions instead of only displaying images fixed in time under artificial conditions, clearly would be of great value.

By means of the present invention, biological specimens can be viewed using an XM or SXM in an ambient environment without subjecting the specimens to large radiation dosage or evacuation. Dynamic processes such as biochemical transport can thus be viewed live under controlled temperature, pH, and chemical concentration. Increasingly smaller targets could be resolved with improvements in beam resolution. At 1000 Å (0.1 μm), for example, certain viruses can be resolved and their movements followed; at 100 Å, certain membrane receptors may become visible and their interactions identified; at 10 Å, even individual amino acids may become visible and the peptide chemistry studied live.

Potential other applications in the fields of chemistry, materials sciences, geology and geochemistry are also numerous. Even at an x-ray beam resolution of 0.1 μm the method and apparatus of the present invention can serve to examine, for example, chemical transport in a microchip at the level of submicron structure, or phase transition in a material at a submicron domain.

According to the method of the present invention, materials such as biological specimens are investigated with use of x-rays. The specimen is able to be investigated under ambient conditions of the environment without being subjected to high radiation dosage or evacuation. The x-rays which are used to investigate the specimen are produced by focusing an accelerated beam of electrons in an evacuated space or chamber onto the surface of a metal foil. The metal foil can be a thin layer, film or coating of a metal on a substrate. The metal foil should be thin and may have a thickness of 10 μm or below, and preferably is thinner, having a thickness of 5 μm or below. More preferably, the foil has a thickness less than 1 μm. The metal of the foil may be silver, aluminum or an aluminum alloy, or any metal which similarly emits bremsstrahlung x-ray photons upon being subjected to an electron beam (e-beam). It is desirable for the foil to be con-structed so that it will conduct and dissipate heat and electrons. For this purpose, the foil can be connected to a heat sink or a conductor for removal of electrons.

The beam of electrons typically is accelerated to an energy within the range of 1-20 keV.

Electrons from the beam of electrons focused on the metal layer are slowed down as they enter the metal region and emit bremsstrahlung x-ray photons. The electrons encounter multiple scattering in the foil and produce photons from each scattering event. Photons created by multiple scatterings are emitted in all directions and their energy levels range from the peak e-beam energy downwards thereby greatly broadening the spatial resolution of the e-beam. In many uses of the invention, beam broadening is an important problem for the SXM and is considered subsequently in the present description. The emitted x-rays substantially comprise x-rays having a wavelength equal to or below 5 Å or an energy equal to or greater than 2 keV.

The substrate which is used to support the metal foil is made of a material which is substantially transparent to x-rays and substantially non-transparent to electrons. Such a material may be made of glass or preferably a polymer. More preferably, the substrate is made of an organic polymer.

The electron beam is focused as a point or spot on the surface of the metal foil, and the area of x-ray peak production is not much bigger than the electron beam spot. However, the resolution may range twice or more the size of the electron spot. Therefore, it is preferred that the beam of electrons should be focused to a beam diameter of less than about 1,000 Å incident on the metal foil. Preferably the beam is focused to a beam diameter of less than about 100 Å and more preferably less than about 10 Å incident on the metal foil. A size for the probe of electrons (the spot size) of as small as 5 Å may be achieved.

The metal foil which faces the evacuated space is supported on a first surface of the support substrate which is substantially transparent to x-rays, the support substrate having a second surface which faces outside the evacuated space. Thus, when a specimen of the material to be investigate is positioned adjacent to the second surface of the substrate, the specimen becomes exposed to the x-rays generated in the metal foil but is outside the evacuated space and thus is not subjected to a vacuum. In this position, the specimen is subjected to x-rays generated in the metal foil, which are emitted in all directions. Some of the emitted x-rays pass through the substrate and also are transmitted through the specimen. In addition, the x-rays entering the specimen cause the generation of fluorescent x-rays from atoms in the specimen.

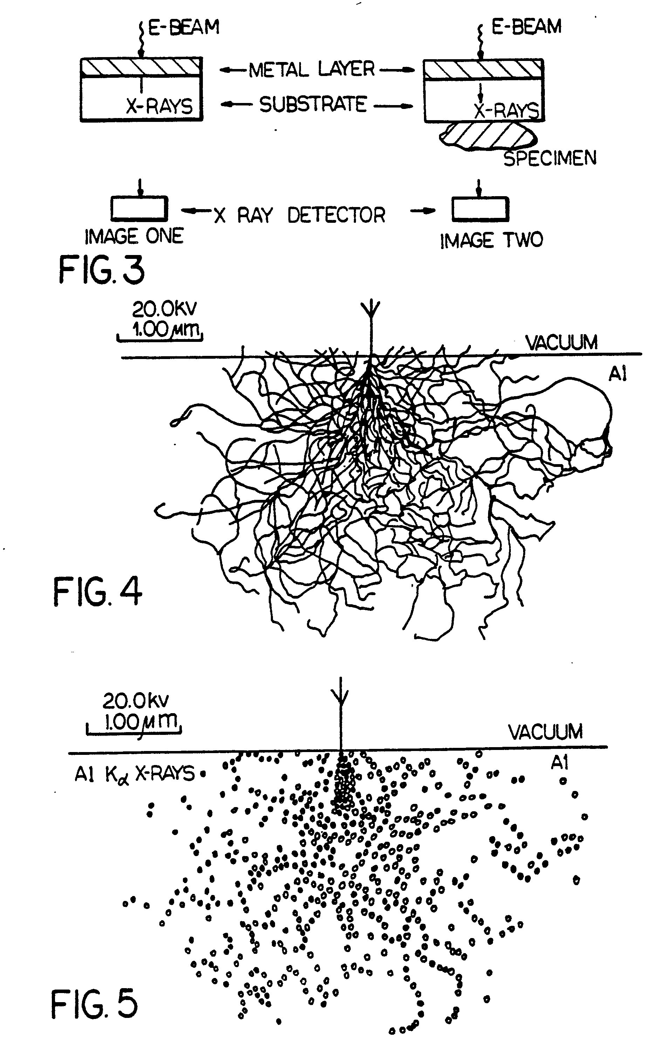

X-rays from said specimen which are characteristic of properties of a region of said specimen are selectively detected. The selective detection can involve the selection of either fluorescent x-rays or transmission x-rays, or both. Transmission x-rays characteristic of properties or structure of a region of the specimen can be selectively detected in the presence of other x-rays representing noise. A selection of transmission x-rays characteristic of the specimen may be done in the following way. The produced x-ray photons, which are far more transparent to the foil than the electrons, leave an aluminum (or other metal) foil and its substrate to interact with the specimen, while a significant number of electrons cannot reach the specimen because the foil and the substrate are substantially non-transparent to electrons. An x-ray detector, positioned to receive x-rays of a certain direction and solid angle, preferably is employed to register the x-rays with and without the specimen. Without the specimen in place, the detector simply reports the "image" of an aluminum layer plus its substrate. As shown in Fig. 3, with the specimen placed in the path of the x-ray beam, the detector reports the foil image plus the specimen. The difference of the two images, from digitized substraction, becomes the designated x-ray image of the specimen alone.

Thus, in accordance with a preferred embodiment of the present invention, the x-rays from said specimen are selectively detected by obtaining a first signal from x-rays detected from said specimen, obtaining a second signal from x-rays detected from the metal foil and substrate in the absence of said specimen, and digitally substracting the second signal from the first signal, thereby obtaining a digitally encoded image of a region of the specimen.

In many cases, it is preferred to limit the thickness of the specimen to 50 $\mu$m or below, and preferably to a thickness of 1-20 $\mu$m.

Beam broadening is a problem to be considered in many instances, depending upon the use which is intended.

Fig. 4 depicts a monte carlo computer simulation of the electron trajectories in an aluminum layer of one micrometer from a point source of 20 keV, and Fig. 5 shows the resultant x-ray productions, the source of these simulations being R. B. Bolon of the General Electric Company, New York.

It can be seen from the monte carlo simulation that an intense region of scattering occurs in a dimension of about 0.1 micrometer. In the present invention, the metal foil, e.g. an aluminum layer, preferably is coated onto an organic substrate. The substrate provides mechanical strength and is useful to support metal layers of different chosen thicknesses. The substrate must provide mechanical strength without generating intense x-rays. The coated aluminum layer facing the incident electron beam generates x-rays, conducts charge, and dissipates heat. The monte carlo calculation in Figs. 4 and 5 assumed a point electron beam to result in a broadened x-ray beam. If the incident electron beam has a finite beam size, this broadened x-ray spot must include one-half of the point broadening to all directions of the finite electron beam size, resulting in a point broadening in addition to the electron beam size.

As electrons are slowed down in the foil through multiple scattering, each scattering gives rise to bremsstrahlung radiation. The distribution of scattering energies is a well defined function of the electron beam energy as well as the foil thickness. If x-rays are selected from only the peak energy, the x-ray beam size would essentially be confined to the incident electron beam spot because no multiple scattering could take place to degrade the beam definition without first degrading the electron energy. A energy dispersive x-ray detector can easily discriminate and select only the peak energy for registration, thereby recording only those x-rays generated from the electron beam spot. A properly positioned axial symmetric diffractor, such as a graphite crystal, also helps to channel higher energy photons from a larger solid angle to reach the detector while blocking the passage of lower energy photons. Another way to channel the distribution of x-rays mainly toward the peak energy is to reduce the thickness of the metal foil so that multiple scatterings in the foil are initially reduced.

Therefore, in the step of detecting x-rays from the specimen, it is a preferred embodiment of the present invention to detect principally only x-rays selected from those having a peak energy or an energy close to the peak energy.

In a preferred embodiment of the invention, the position of the accelerated electron beam is moved so that an area of metal foil is scanned by the beam of electrons, there providing a SXM. The scanning movement of the electron beam is done by conventional techniques as are known in the operation of a SEM. This may be done, for example, by utilizing a modified SEM wherein the electron beam is accelerated and scanned, but the specimen is placed outside of the SEM adjacent to an aperture holding a metal foil exposed to the scanning electron beam and supported by a support substrate having a surface outside the SEM against which the specimen is located. In that way, signals representative of an image of a region of the specimen are obtained, by the processing of detected x-rays representative of different parts of the region obtained during the scanning process. A digitally encoded image of a region of the specimen is obtained and amplified, and may be displayed, such as by means of an electron beam in a cathode ray tube. As is conventional, the electron beam in said cathode ray tube is scanned in synchronization with the scanning of the beam of electrons directed to the metal foil.

By selective detection of fluorescent photons, the obtained image can be element specific. For this purpose an energy dispersive x-ray detector is used which is also energy discriminating. Transmission x-rays leave the specimen in a forward direction (downstream direction of the e-beam) and would represent noise or background when it is desired to selectively detect fluorescent photons. Fluorescent x-rays do not have a forward intensity peak. To enhance the signal-to-noise ratio of the fluorescent x-ray signals, the fluorescent x-ray detector should be placed outside of the main e-beam path. It is a further preferred embodiment of the invention to selectively detect fluorescent x-rays emitted from the specimen.

Fluorescent x-rays characteristic of a specific chemical element may be detected and a signal produced which is representative of the concentration of the specific chemical element in the specimen. Thus, the energy selectivity of the x-ray detector can be used to analyze the chemical composition of the specimen, i.e., selected to report the characteristic fluorescent x-rays. In order to retain the beam definition where only the peak x-ray energy is detected, the electron beam energy should be controlled to be near a major absorption edge of the element in question. In other words, each element of interest in the specimen should be examined with an electron beam energy set at near the characteristic energy of the element for a good beam definition. Searching through a series of elements thus requires a dynamic energy scan, and this energy scan is independent of the positional scan described above for the SXM of the present invention. This method can be used as a chemical scan of sub-micron dimension with or without the positional variation (scanning the electron beam over a region of the metal · foil). A static spot analysis of chemical composition can be obtained without positional scanning, i.e. with the XM of the present invention, and provides important information. Repeated over a time interval, the changes in elemental or chemical composition of a region or a spot in the specimen can be determined.

Accordingly, in the aspect of the present invention wherein fluorescent x-rays characteristic of a specific chemical element are detected, the energy of the accelerated beam of electrons is preferably maintained at substantially the same as the energy of the fluorescent x-rays characteristic of the specific chemical element. Moreover, in this embodiment of the invention, the energy of the accelerated beam of electrons may be sequentially changed to provide a series of different energies corresponding to different energies of fluorescent x-rays characteristic of the different chemical elements, with production of signals representing the concentration of a plurality of such chemical elements in the specimen. The method of the invention further includes obtaining different signals over a period of time which represent the changing concentrations of those different chemical elements in the specimen. By further combining the technique of scanning an area of the metal foil with the production of signals over a period of time representative of changing concentrations of different chemical elements, the resulting signals produced are representative of changing concentrations of different elements throughout a region of the specimen.

For image formation representing chemical analysis, a dynamic electron beam energy scan may be employed together with gate variation of the x-ray detector. The dynamic energy scan controls the anode voltage of an electron gun and associated electromagnetic lenses as well as the detector window. These controls are useful to maintain a good x-ray beam definition.

The apparatus of the invention will now be described with reference to the drawings.

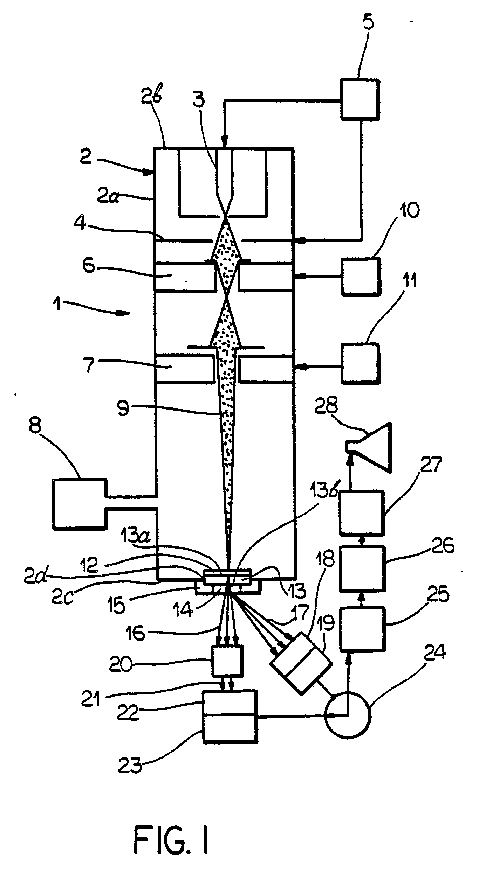

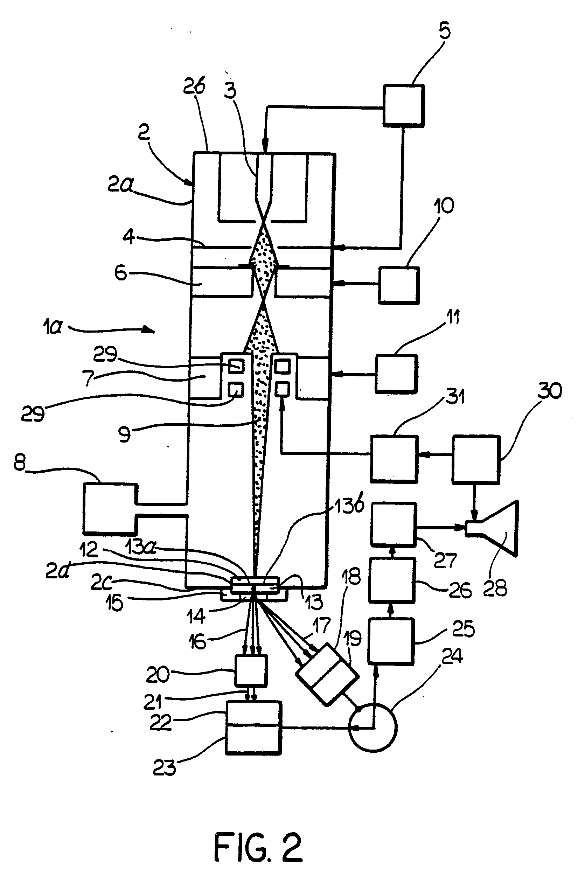

Fig. 1 illustrates an embodiment of an XM, shown generally as 1, of the present invention and Fig. 2 illustrates a SXM embodiment, shown generally as 1a, of the present invention. As shown in both Figs. 1 and 2, the apparatus of the invention comprises a chamber 2 which comprises a generally elongated chamber housing 2a and at opposite ends of said housing a first end wall 2b and a second end wall 2c. The second end wall 2c has an aperture 2d. A support substrate 13 is mounted in or adjacent to aperture 2c, the support substrate 13 being composed of a material substantially transparent to x-rays and having a first surface 13a facing the interior of chamber 2 and a second surface 13b facing outwardly of said chamber 2. A metal foil 12 is disposed on first surface 13a of said substrate 13. The metal foil is a thin layer but for clarity is exaggerated in thickness in the Figs. 1 and 2. Metal foil 12 thus is in a position exposed to the interior of chamber 2. The chamber is capable of being evacuated and maintained under vacuum, for example by means of vacuum pump 8.

The apparatus of the invention further comprises means for producing and accelerating a beam of electrons 9 within said chamber 2 along a beam path. The electron beam may be produced by an electron gun 3 and accelerated by anode 4, with electric current supply 5 supplying filament heating power to the electron gun 3 and high voltage power to anode 4, through electric current conductors shown in Figs. 1 and 2 by arrows. The beam of electrons alternatively may be generated outside of chamber 2 by other means.

Said chamber 2 preferably is an elongated hollow body, with the means for producing and accelerating the beam of electrons 9 being adjacent to the first end wall 2b, and the support substrate 13 being mounted in second end wall 2c, the electron beam path extending along a lengthwise axis in a downstream direction from the means for producing and accelerating the beam of electrons to the metal foil 12.

Means is provided for focusing the beam of electrons 9 within said chamber. The means for focusing may comprise electromagnetic condenser lens 6 and objective lens 7, electric current supply 10 for the condenser lens and electric current supply 11 for the objective lens, the electric current conductors being depicted by arrows.

Means such as specimen holder 15 is provided for positioning a specimen 14 (shown exaggerated in thickness) outside said chamber 2 adjacent to the second surface 13b of substrate 13. Specimen holder 15 may comprise a cup for specimens dispersed in water or other liquid, or a clamp for solid phase specimens.

X-ray detector 18 for fluorescent x-rays 17 and/or x-ray detector 22 for transmission x-rays 16 are disposed in a location where they are capable of detecting x-rays leaving said specimen 14. Cooperating with each x-ray detector 18 and 22 is a preamplifier 19 and 23, respectively. X-ray detector selector switch 24 is provided to divert the output of one or the other preamplifier to amplification, signal processing and display units. Also included within the scope of the invention, although not shown, is a switching arrangement whereby the output of both detectors may be simultaneously used. Further, additional x-ray detectors may be employed, or only one detector may be provided.

X-ray detector 22 is located downstream from the means for positioning a specimen, in the path of axial x-rays 21 transmitted from specimen 14, and said means for positioning a specimen and said x-ray detector 22 are disposed in alignment with the lengthwise axis of chamber 2.

X-ray detector 18 is positioned out of alignment with the lengthwise axis of chamber 2, and is substantially out of the path of x-rays 16 transmitted through said specimen 14, and is in the path of fluorescent x-rays 17 emitted from specimen 14. Although x-ray detector 18 for fluorescent x-rays is shown in Figs. 1 and 2 as preferably being disposed outside of chamber 2, this detector may instead be positioned inside chamber 2 or disposed outside chamber 2 adjacent to or in an aperture in chamber housing 2a (not shown in the figures), said aperture being sealed by a window or detector window which is transparent to x-rays. Detector 18 can be placed in the alternative positions indicated or it can be maintained in the position shown in the drawings and an additional fluorescent x-ray detector can be placed in the alternative positions.

The x-ray detectors are preferably energy dispersive and energy discriminating. X-ray detector 22 of this type is thereby capable of selecting and recording a narrow range of peak energy and energies close to peak energy, to assist in the recording of only the x-rays generated from the electron beam spot.

An axial symmetric defractor 20 may also be included, to direct x-rays 21 having energies close to peak energy towards x-ray detector 22, while blocking the passage of lower energy x-rays. The defractor 20, which may comprise a graphite crystal, is disposed between the specimen holder 15 and x-ray detector 22, in axial alignment with the lengthwise axis of chamber 2.

For recording or displaying information obtained from detected x-ray signals, the apparatus of the invention may include means for amplifying a signal representative of the detected x-rays. For this purpose, the output from the preamplifier 19 or 23 is conducted by detector selector switch 24, to a pulse amplifier and a multi-channel analyzer 25. The signal from analyzer 25 is transmitted to A/D (analog-to-digital) converter, memory and processor 26, the output of which may be conducted for display to a video amplifier 27 which controls a display unit comprising CRT (Cathode ray tube) 28. The CRT display unit may be a computer monitor.

Energy dispersive x-ray detectors usually require a multi-channel analyzer to distinguish one pulse height from another. But with the use of personal computers, the multi-channel analyzer and discriminator, together with the A/D convertor, digitized image memories and processing can all be processed by a PC-AT with a modification board. The high speed of an AT unit is needed in order to complete the data processing in a reasonable time. The imaged output can be handled on the AT computer by using a high-resolution extended graphics board in combination with a high-resolution color monitor which produces a color image, with each separate color representing a different element. The minimum resolution desirably should be 640 x 400 pixels.

A preferred embodiment of the apparatus of the present invention is a SXM as illustrated in Fig. 2. The SXM apparatus as illustrated further comprises means for scanning the beam of electrons 9 over an area of the metal foil 12. This is accomplished by further modification of the Fig. 1 apparatus, as shown in Fig. 2, by the provision of a scanning coil 29 which can sweep the electron beam in a scanning pattern generated by a scanning generator 30, the output of which is directed to a scanning amplifier 31 which in turn is connected to scanning coil 29. The output of the scanning generator 30 also is directed to CRT display unit 28 so that the cathode ray tube is scanned in synchronization with the scanning of the metal foil.

It is contemplated that the inventive concepts herein described may be variously otherwise embodied, and it is intended that the appended claims be construed to include alternative embodiments of the invention except insofar as limited by the prior art.

In the above disclosure, the architecture of a usual scanning electron microscope (SEM) was used, but in place of the SEM's focal position of the specimen, a thin foil with a metal coating is instead located. The said foil serves several functions unrelated to the usual SEM. It seals the vacuum of the e-beam chamber so that while one side of the foil faces the evacuated e-beam, the other side is exposed to the ambient pressure and humidity; it conducts charge from the e-beam; it dissipates heat from the beam irradiation; and it generates x-rays to illuminate the specimen positioned outside the evacuated chamber.

An important feature of the above disclosure is that a very fine x-ray beam spot, almost as small as the e-beam spot of the SEM, is created for the x-ray microscope. As the e-beam slows down in metal, it generates x-rays and the beam spot diffuses and broadens along the way, but only the relatively un-broadened x-ray spot is utilized for the specimen image. This relatively un-broadened x-ray beam is chosen by selecting the peak x-ray photon energies originating rom the e-beam prior to its energy degradation and broadening. Another mode of operation is to use a very thin metal layer whose thickness is of the order of the designated x-ray beam spot size. Once the fine x-ray spot is realized, other imaging parameters such as beam brightness, exposure time, detector size, image resolution, and contrast can all be dealt with separately. Iodine, for example, is a heavy element, which provides contrast to the normal biological specimens of light elements, and Iodine can be incorporated into various proteins and peptides without causing major alteration to the biochemical structure. Similarly, Bromine, in the form of BrdU, can be incorporated into the nucleic acids for enhancing the contrast. To achieve a brighter x-ray for a reduced exposure time, the e-beam energy can be raised, albeit at the price of a reduced contrast.

Different x-ray detectors also may be used as will now be discussed. Using projection radiography as an example to illustrate the geometry of the arrangement, when a specimen image is projected from a point beam source, the following diagram of resolution and angular relationship holds:

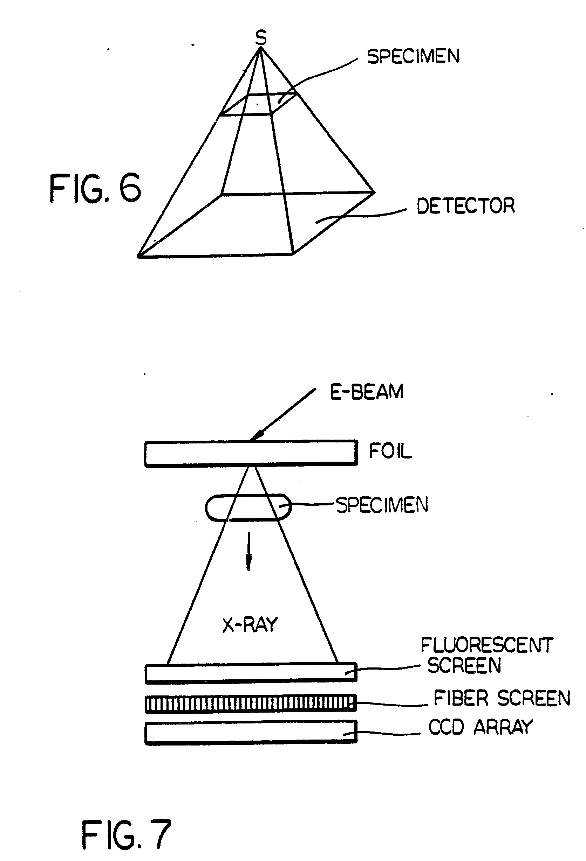

For a given distance between the source, the specimen, and the beam detectors, the smaller the detector pixels, the finer the image resolution. Assuming the specimen and the detectors are separated from the source S by 10 Nm and 1 cm respectively, and for a pixel of 5 Nm, the result is a specimen dimension of which is typically the resolution of the SEM (see Fig. 6).

To select from the x-ray photons only those with the peak energy implies that the detectors must be able to discriminate x-ray energies, or be "energy dispersive" for the x-rays. The usual optical charged-coupled-deviced (CCD) has a very shallow depletion region and cannot accommodate x-ray photons to deposit their energies in the depleted region. CCD's are fabricated from a low resistivity silicon material. High resistivity material at a value up to 10,000 ohm-cm is currently available and can be fabricated for the x-ray CCD detectors with a very thick depletion region. Another important advantage of using the small pixel CCD is its small capacitance in each pixel, therefore very low noise; of the order of the Si(Li) detector operating at the liquid nitrogen temperature while operating CCD at the room temperature. A series of recent developments in using the CCD's for the x-rays can be found in several articles in OPTICAL ENGINEERING, Vol. 26, No. 2,8, and 10; 1987.

Without a CCD's specifically designated for x-rays, an optical CCD with very shallow depletion region can also serve for x-ray detection with the help of a fluorescent screen. X-rays shining on the fluorescent screen would be converted into optical photons and be detected by the optical CCDs. In order to eliminate the wide angled "stray" photons from the fluorescent screen, a fiber screen with low numerical aperature can be placed between the fluorescent screen and the detector array: In this arrangement, the detectors are no longer energy discriminating. To help channeling only the peak x-ray photons to reach the detectors the metal coating can be made very thin, as thin as the designated x-ray beam spot size. In addition the e-beam can be tilted to benefit from the maximum dipole radiation from the primary e-beam prior to its diffusive scattering (see Fig. 7).

## Claims

1. A method of investigating materials by the use of x-rays, which comprises focusing an accelerated beam of electrons (9) in an evacuated space on a metal foil (12) facing said evacuated space, said metal foil (12) being supported on a first surface 13 a of a support substrate (13) which is substantially transparent to x-rays and has a second surface 13 b outside said evacuated space, thereby generating x-rays in said metal foil (12), placing a specimen (14) of a material to be investigated adjacent to said second surface 13 b of said substrate 13 in a position exposed to the x-rays generated in said metal foil (12), and selectively detecting x-rays from said specimen (14) which are characteristic of properties of a region of said specimen (14).

2. A method according to claim 1, wherein said metal foil (12) has a thickness of less than $1\mu m$.

3. A method according to claim 1 or 2, wherein a second signal is obtained from x-rays detected from the metal foil (12) and substrate (13) in the absence of said specimen (14), and said second signal is digitally subtracted from said first signal, thereby obtaining a digitally encoded image of a region of the specimen (14).

4. A method according to any one of the preceding claims, wherein only x-rays selected from those having a peak energy or an energy close to the peak energy are detected.

5. A method according to any one of the preceding claims, wherein an area of the metal foil (12) is scanned by the beam of electrons (9).

6. A method according to any one of the preceding claims, wherein a digitally encoded image of a region of the specimen is amplified and displayed by an electron beam in a cathode ray tube (28), said electron beam in said cathode ray tube (28) being scanned in synchronization with the scanning of the beam of electrons (9) directed to the metal foil (12).

7. A method according to any one of the preceding claims, wherein fluorescent x-rays (17) emitted from said specimen are selectively detected.

8. A method according to claim 7, wherein fluorescent x-rays (17) characteristic of a specific chemical element are detected and a signal is produced which is representative of the concentration of said specific chemical element in said specimen.

9. A method according to claim 8, wherein the energy of the accelerated beam of electrons (9) is substantially the same as the energy of the fluorescent x-rays (17) characteristic of said specific chemical element.

10. A method according to claim 9, wherein the energy of the accelerated beam of electrons (9) is sequentially changed to provide a series of different energies corresponding to different energies of fluorescent x-rays (17) characteristic of different chemical elements, and signals are produced which represent the concentration of a plurality of chemical elements in said specimen.

11. A method according to any one of claims 1-5 or 7-10, wherein the x-rays (16, 17) are detected by use of a charge-coupled device as detector.

12. An apparatus for investigating materials by the use of x-rays, which comprises:
a chamber (2) adapted to be maintained under vacuum;
said chamber (2) having a wall 2 c which has an aperture 2 d in which is mounted a support substrate (13) composed of a material substantially transparent to x-rays, said support substrate (13) having a first surface 13a facing the interior of said chamber (2) and a second surface 13 b facing outside said chamber (2), said first surface (13 a) of the support substrate (13) having thereon a metal foil (12) exposed to the interior of the chamber (2);
means (6, 7) for focusing a beam of electrons (9) within said chamber (2) on said metal foil (12);
means (15) for positioning a specimen (14) outside said chamber (2) adjacent to said second surface 13 b of the support substrate; and
at least one x-ray detector (18, 22) positioned to detect x-rays (17, 16) leaving said specimen (14).

13. An apparatus according to claim 12, wherein an x-ray detector (22) is positioned downstream from said means (15) for positioning a specimen, in the path of x-rays (16) transmitted from said specimen (14), and said means (15) for positioning a specimen and said x-ray detector (22) are disposed in alignment with the path of said beam of electrons (9); and or an x-ray detector (18) is positioned out of alignment with the path of said beam of electrons (9) substantially out of the path of x-rays (16) transmitted through said specimen (14) and in the path of fluorescent x-rays (17) emitted from said specimen (14).

14. An apparatus according to claim 13, wherein said x-ray detector (18, 22) is an energy dispersive x-ray detector capable of selecting and recording a narrow range of peak energy and energies close to peak energy.

15. An apparatus according to claim 14, further comprising an axial symmetric diffractor (20) for directing x-rays (21) having energies close to peak energies towards said x-ray detector (22) while blocking the passage of lower energy x-rays, said diffractor (20) being located between said means (15) for positioning a specimen (14) and said x-ray detector (22) and being axially in alignment with the path of said beam of electrons (9).

16. An apparatus according to any one of claims 12-15, further comprising means (29, 30) for scanning said beam of electrons (9) over an area of the metal foil (12).

17. An apparatus according to claim 16, further comprising:
means (25) for amplifying a signal representative of detected x-rays (16, 17);
means (26) for converting the amplified signal into a digitally encoded image of a scanned area;
means (27, 28) for amplifying and displaying said image, said means for amplifying and displaying comprising a cathode ray tube (28) adapted to be scanned by an electron beam, said cathode ray tube (28) being adapted to be scanned in synchronization with the scanning of the metal foil (12).

18. An apparatus according to any one of the preceding claims, wherein the metal foil (12) has a thickness of less 1µm.

19. An apparatus according to any one of the preceding claims, including means (3, 4) for producing and accelerating said beam of electrons (9) said means also capable of dynamically scanning the energy of said beam electrons (9).

20. An apparatus according to any one of 12 to 16, 18 or 19, in which the detector is a charge-coupled device.

FIG. 1

FIG. 2

EP 0 319 912 A2

E-BEAM

METAL LAYER

X-RAYS    SUBSTRATE

SPECIMEN

IMAGE ONE    X RAY DETECTOR    IMAGE TWO

FIG. 3

20.0KV
1.00 μm

VACUUM

Al

FIG. 4

20.0kv
1.00 μm

VACUUM

Al Kα X-RAYS    Al

FIG. 5

S

SPECIMEN

FIG. 6

DETECTOR

E-BEAM

FOIL

SPECIMEN

X-RAY

FLUORESCENT
SCREEN

FIBER SCREEN

CCD ARRAY

FIG. 7